(19) **Europäisches Patentamt**

**European Patent Office**

**Office européen des brevets**

(11) Veröffentlichungsnummer: **0 103 043**
**B1**

(12) **EUROPÄISCHE PATENTSCHRIFT**

(45) Veröffentlichungstag der Patentschrift:
18.03.87

(21) Anmeldenummer: **82108483.7**

(22) Anmeldetag: **15.09.82**

(51) Int. Cl.⁴: **H 01 L 29/60, G 11 C 11/34**

(54) CMOS-Speicherzelle mit potentialmässig schwebendem Speichergate.

(43) Veröffentlichungstag der Anmeldung:
21.03.84 Patentblatt 84/12

(45) Bekanntmachung des Hinweises auf die Patenterteilung:
18.03.87 Patentblatt 87/12

(84) Benannte Vertragsstaaten:
DE FR GB IT NL

(56) Entgegenhaltungen:
DE-A-2 931 734
US-A-4 175 290

RCA TECHNICAL NOTES, NR. 1185, Juni 1977,
Seiten 1-4, Princeton, N.J., USA L.B. MEDWIN et
al.: "FACMOS EAROM"
PATENTS ABSTRACTS OF JAPAN, Band 3, Nr. 38,
30. März 1979, Seite 34 E101
PATENTS ABSTRACTS OF JAPAN, Band 3, Nr. 99,
22. August 1979, Seite 143 E 132

(73) Patentinhaber: **Deutsche ITT Industries GmbH,
Hans- Bunte- Strasse 19 Postfach 840, D-7800
Freiburg (DE)**
(84) Benannte Vertragsstaaten: **DE**

(73) Patentinhaber: **ITT INDUSTRIES INC., 320 Park
Avenue, New York, NY 10022 (US)**
(84) Benannte Vertragsstaaten: **FR GB IT NL**

(72) Erfinder: **Adam, Fritz Günter, Dr. rer.nat. Dipl.-
Phys., Furtwänglerstrasse 10, D-7800 Freiburg i.
Br. (DE)**

(74) Vertreter: **Morstadt, Volker, Dipl.- Ing., c/o
Deutsche ITT Industries GmbH
Patent/Lizenzabteilung Postfach 840 Hans- Bunte-
Strasse 19, D-7800 Freiburg/Brsg. (DE)**

## Beschreibung

Nichtflüchtige Halbleiterspeicherzellen, die mit sehr kleinen Programmierströmen auskommen, sind für den Anwender im Hinblick auf eine Minimierung der Verlustleistung von elektrisch programmierbaren Speichermatrizen (EEPROM) besonders interessant. In diese Kategorie von Speicherzellen gehören MNOS-Speicherzellen und Speicherzellen mit potentialmäßig schwebendem Speichergate die über einen Tunnelinjektor umgeladen werden. Die letzteren zeichnen sich gegenüber MNOS-Speicherzellen durch bessere Haltezeiten und Standzeiten aus, wobei die Haltezeit die Dauer der Aufrechterhaltung der eingespeicherten Daten (Retention) und die Standzeit die Zahl der Umprogrammierungen (Endurance) angibt, die unbeschadet überstanden werden. Eine Speicherzelle der letztgenannten Art ist z. B. aus der Zeitschrift "Electronics" vom 28. Februar 1980, Seiten 113 bis 117, bekannt. Diese sogenannten "Floating-Gate"-Speicherzellen gewinnen beim Anwender und beim Hersteller auch dadurch an Beliebtheit, das ihre Herstellungstechnik einen höheren Grad von Kompatibilität mit modernen Standardtechnologien aufweist.

Aus "1980 IEEE International Solid-State Circuits Conference, Digest of Technical Papers", Seiten 152 und 153, ist eine elektrisch löschbare Speichermatrix mit n Zeilen und m Spalten angeordnete Speicherzellen bekannt. Jede der Speicherzellen enthält einen Tunnelinjektor, der in der Lage ist, in beiden Richtungen zu einem elektrisch schwebendem Speichergate Elektronen durch eine ausreichend dünne Oxidschicht tunneln zu lassen. Der Injektor jeder Speicherzelle ist einerseits über die Source-Drain-Strecke eines Speichertransistors mit einer ersten Bitleitung und andererseits über die Source-Drain-Strecke eines Auswahltransistors mit einer zweiten Bitleitung verbunden, während das Steuergate des Speichertransistors an einer Programmierleitung angeschlossen ist. Das Gate des Auswahltransistors liegt an einer Zeilenwahlleitung, über die zeilenweise die n Speicherzellen jeder Zeile angewählt werden können. Die Erfindung beschäftigt sich mit einer ähnlich aufgebauten Speicherzelle mit einem potentialmäßig schwebendem Speichergate.

Die Erfindung betrifft somit eine elektrisch programmierbare Speicherzelle gemäß dem Oberbegriff des Anspruchs 1.

Zur Lösung des bereits einleitend angesprochenem Problems der Verringerung der Verlustleistung ist es bekannt, die Peripherie der Speichermatrix in CMOS-Technologie mit Hilfe von CMOS-Gattern zu realisieren. Eine solche Lösung ist aus "1982 International Solid-State Circuits, Digest of Technical Papers"" (Febr. 1982), Seiten 110 und 111, bekannt. Bei dieser bekannten Speichermatrix gibt es jedoch zwei Eigenschaften, die den erstrebten Eigenschaften einer reinen CMOS-Schaltung noch nicht entsprechen:

1) Beim Lesen der gespeicherten Daten wird Gleichstromleistung verbraucht, die über das bei CMOS-Schaltungen übliche Sperrstromniveau hinausgeht.

2) Die beim Null-Schreiben (Wo) dem Injektor zugeführte Spannung, welche ein Tunneln von Elektronen aus dem Speichergate in den Injektor bewirkt, erreicht nicht den vollen Wert der zur Verfügung stehenden Programmierspannuüg $V_p$, sondern bleibt um die Schwellenspannung $U_t$ des Auswahltransistors plus Substrateffektspannung darunter.

Der Erfindung liegt die Aufgabe zugrunde, eine Floating- Gate-Speicherzelle anzugeben, die in allen Funktionen, Programmierung, Lesen und Warten die erwünschten Eigenschaften einer reinen CMOS-Schaltung aufweist, Das heißt, es soll insbesondere auch beim Lesen der gespeicherten Daten keine größere Gleichstromleistung als die durch Sperrströme verursachte anfallen, und die Zelle soll auch beim Null-Schreiben die Zuführung der vollen zur Verfügüng stehenden Programmierspannung an den Injektor erlauben.

Es ist daher eine weitere Aufgabe der Erfindung, einen Floating-Speicher anzugeben, der mit einer kleineren Programmierspannung, als es bisher möglich war, arbeiten kann.

Diese Aufgaben werden bei einer elektrisch programmierbaren Speicherzelle gemäß dem Oberbegriff des Anspruchs 1 durch die im kennzeichnenden Teil dieses Anspruchs 1 angegebene Ausbildung gelöst.

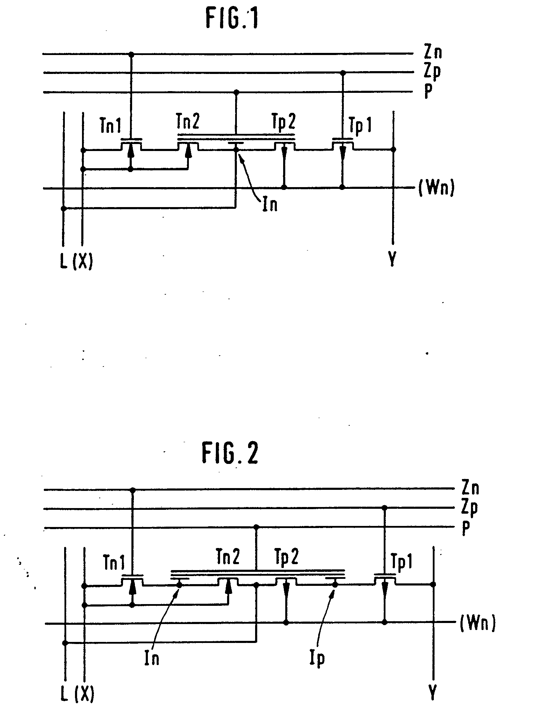

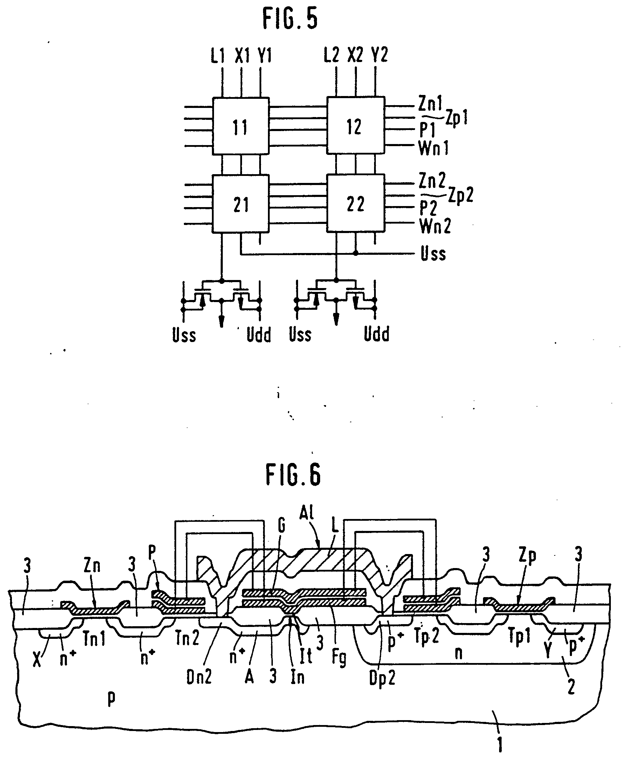

Die Erfindung wird im folgenden anhand von Ausführungsbeispielen unter Heranziehung der Zeichnung erläutert,

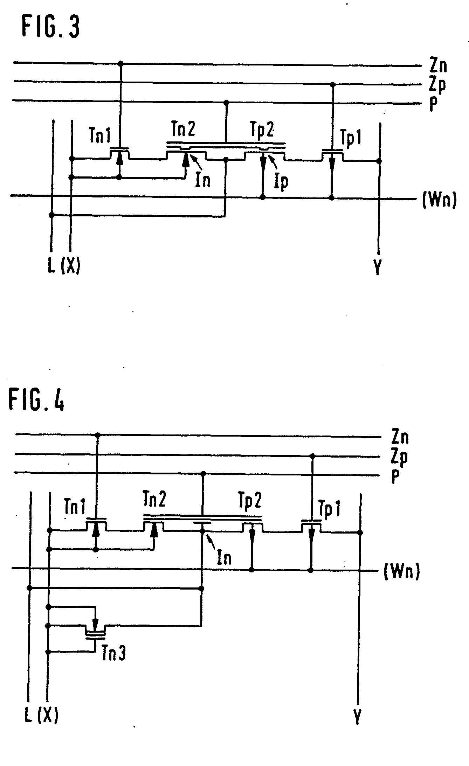

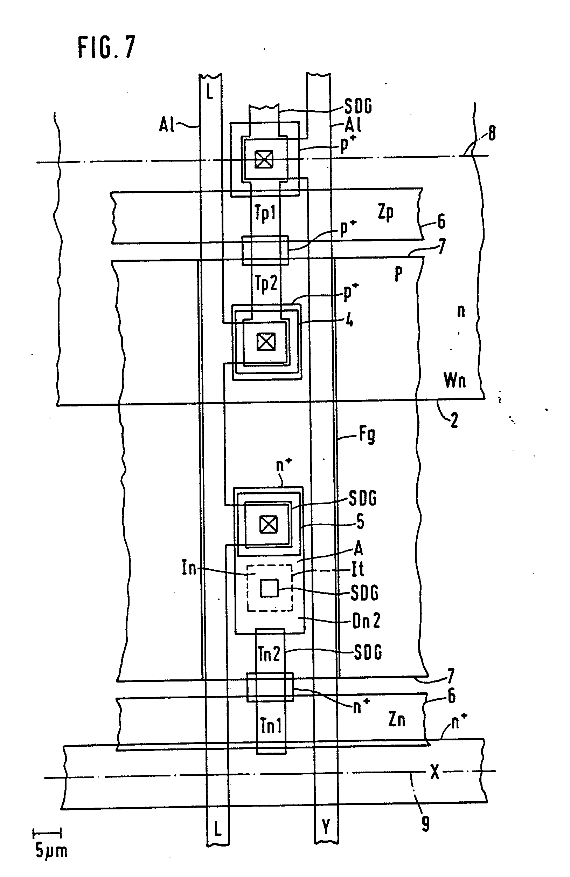

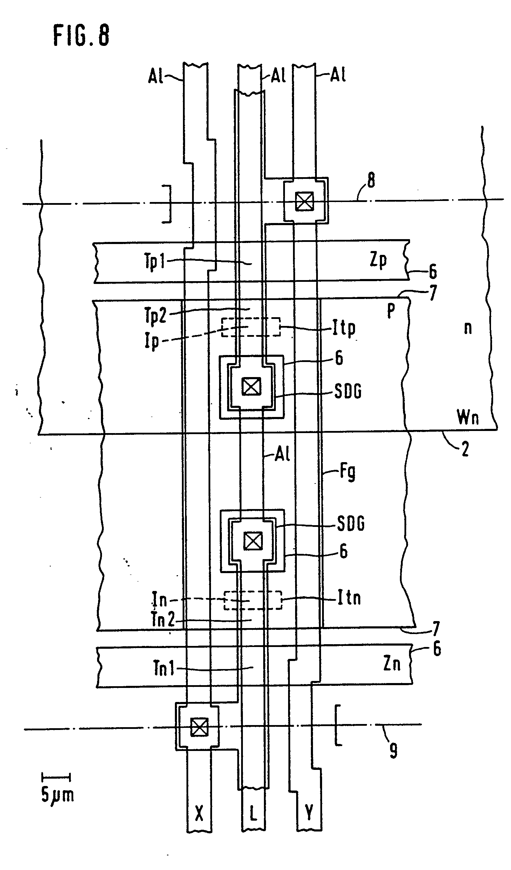

deren Fig. 1 den schaltungsmäßigen Aufbau der ersten Ausführungsform einer elektrisch programmierbaren Speicherzelle nach der Erfindung zeigt,

deren Fig. 2, je einen schaltungsmäßigen Aufbau von drei 3 und 4 weiteren Ausführungsformen der Speicherzelle nach der Erfindung betreffen,

deren Fig. 5 die Verwendung von Speicherzellen gemäß der Figuren 1, 2, 3 und 4 in einer programmierbaren Matrix veranschaulichen,

deren Fig. 6 die monolithische Integration einer Speicherzelle nach der Fig. 1 in Teilquerschnittsansicht zeigt, deren Fig. 7 und 8 die Auslegung von Speicherzellen gemäß den Fig. 1 bzw. 3 in Aufsicht auf eine Speichermatrix ausschnittsweise veranschaulichen.

Wie die Figuren 1 bis 4 zeigen, ist allen Ausführungsformen der Speicherzelle nach der Erfindung die Reihenschaltung von 4 Feldeffekttransistoren zwischen der ersten Bitleitung X und der zweiten Bitleitung Y gemeinsam, wobei die beiden inneren Transistoren $Tn2$ und $Tp2$ ein komplementäres Paar von Speichertransistoren sind, die mit ihren Drainelektroden im Mittelpunkt der Reihenschaltung miteinander und mit einer der betreffenden Matrixspalte gemeinsamen Leseleitung L verbunden sind. Ihre Polyziliziumgateelektroden sind miteinander verbunden, als gemeinsames Speichergate Fg gegen die Umgebung isoliert und kapazitiv an die darüber liegende, der betreffenden Zeile gemeinsame Steuerelektrode G angekoppelt. Sie bestehen vorzugsweise aus n-dotierten Polysilicium, wie es bei den Ausführungsbeispielen der Fall ist.

Allen Ausführungsformen ist auch gemeinsam, daß die außen liegenden Auswahltransistoren Tn1 und Tp1 der Reihenschaltung in ihrem Leitungstyp mit dem jeweils benachbarten Speichertransistoren Tn2 bzw. Tp2 übereinstimmen und daß sie über getrennte Zeilenleitungen Zn und Zp angesteuert werden.

Ferner ist allen Ausführungsformen gemeinsam, daß die n-dotierten wannenförmigen Substratzonen Wn zeilenweise angeordnet, aber galvanisch untereinander verbunden sind und gemeinsam für die ganze Speichermatrix potentialmäßig gesteuert werden.

Die Programmierung der Speicherzelle erfolgt durch Umladen des Speichergates Fg mit Hilfe eines Tunnelstroms, der bei genügend hoher Feldstärke durch das sehr dünne (etwa 10 bis 20 nm) Tunneloxid einer Injektoreinrichtung unterhalb des Speichergates fließt.

Die Injektoreinrichtung befindet sich im Bereich des Speichergates Fg und kann aus einem Injektor In oder aus zwei Injektoren In und Ip bestehen. Der Injektor In befindet sich mit seiner Tunneloxidschicht in jedem Fall auf der N-Kanalseite der Reihenschaltung und zwar innerhalb von Source-, Drain- oder Kanalzone des N-Kanal-Speichertransistors Tn2. Entsprechend befindet sich der Injektor Ip auf der P-Kanalseite innerhalb von Source-, Drain- oder Kanalzone des P-Kanal-Speichertransistors Tp2.

Bei den Ausführungsformen der Figuren 1 und 4, bei denen die Injektoreinrichtung zwischen den beiden Speichertransistoren Tn2 und Tp2 im Mittelpunkt der Schaltung liegt, ist ein einzelner Injektor In an der Drainzone Dn2 des N-Kanal-Speichertransistors Tn2 vorhanden wie die Figuren 6 und 7 veranschaulichen. Bei dieser Ausführungsform ist der Injektor In mit seinem Tunneloxid It an einem Ansatz A der Drainzone Dn1 ausgebildet. Ein solcher N-Injektor leistet sowohl das "Eins'''-Schreiben W1 wie auch das "Null'''-Schreiben Wo, da beiderseits der Tunnelisolatorschicht It n-dotiertes Silicium vorhanden ist, das N-Polysilicium des Speichergates Fg darüber und das einkristalline N-Silicium darunter. Diese n-dotierten Halbleiter sind in der Lage, Tunnel-Elektronen in beiden Richtungen durch das Tunneloxid zu schicken, welches vorzugsweise aus thermisch gewachsenem Siliciumdioxid besteht und eine Dicke von 10 nm bis 20 nm aufweist.

Die CMOS-Speicherzelle nach der Erfindung erlaubt es, beim Wo-Schreiben die volle, an der zweiten Bitleitung Y angelegte Programmier-Spannung Up bis zum Mittelpunkt der Schaltung, wo die Leseleitungs L abzweigt, durchzuschalten. Desgleichen kann beim W1-Schreiben das Nullpotential Uss von der ersten Bitleitung X über die N-Kanaltransistoren Tn1 und Tn2 Mittelpunkt geschaltet werden. Im Mittelpunkt genügt daher ein einzelner Injektor. Dies gilt jedoch nicht für die Ausführungsformen gemäß den Figuren 2 und 3.

Bei der Ausführungsform nach Fig. 2 besteht die Injektoreinrichtung aus einem ersten Injektor In und einem zweiten Injektor Ip, jeweils zwischen einem Speüchertransistor und einem Auswahltransistor des gleichen Typs. Dabei besorgt der Injektor In das W1-Schreiben, wobei Elektronen ins Speichergate Fg fließen, während der Injektor Ip für das Wo-Schreiben zuständig ist, wobei die Elektronen aus dem Speichergate, welches aus n-dotierten Polysilicium besteht, in die darunter liegende p-dotierte Substratzone 2 fließen.

Bei der Ausführungsform nach Fig. 3 ist je ein Injektor innerhalb der Kanalzone jeder der beiden Speichertransistoren Tn2 und Tp2 untergebracht. Beim W1-Schreiben ist der Kanal des N-Kanal-Speichertransistors Tn2 leitend gesteuert und daher in der Lage, die für den Tunnelstrom benötigten Elektronen nachzuliefern.

Bei allen Ausführungsformen der Speicherzelle nach der Erfindung liegen die Gateelektroden der N-Kanal-Auswahltransistoren Tn1 zeilenweise an der Zeilenwahlleitung Zn und die der P-Kanal-Auswahltransistoren zeilenweise an der Zeilenwahlleitung Zp.

Zusammen mit der Programmierleitung P hat die Speicherzelle damit insgesamt 3 Wortleitungen. Über diese und über die zweite Bitleitung Y erfolgt die zeilen- bzw. spaltenweise Steuerung der Speicherzellen in der Speichermatrix für die Funktionen:
- Zeilenweises Löschen durch "Eins'''-Schreiben W1,
- zeilenweises Dateneinschreiben durch "Null''Schreiben Wo einzelner Bits in der Zeilen,
- zeilenweises Datenauslesen R über die Leseleitung L und
- Warten (Standby St).

Tabelle 1 gibt als Beispiel ein Programmierschema für die Zeiten und Spalten einer 2x2-Speichermatrix mit vier CMOS-Speicherzellen 11, 12, 21 und 22 nach der Erfindung gemäß der Fig. 5.

**Tabelle I**

| Zelle | 11 | 12 | 21 | 22 |
|---|---|---|---|---|
| Funktion | Zn1 Zp1 P1 Y1 | Zn1 Zp1 P1 Y2 | Zn2 Zp2 P2 Y1 | Zn2 Zp2 P2 Y2 |
| W1 (11,12) | Udd Udd Up Uss | Udd Udd Up Uss | Udd Udd Uss Uss | Udd Udd Uss Uss |
| Wo (11) | Uss Uss Uss Up | Uss Uss Uss Uss | Udd Up Uss Up | Udd Up Uss Uss |
| R (11,12) | Udd Uss Uss Udd | Udd Uss Uss Udd | Uss Udd Uss Udd | Uss Udd Uss Udd |
| St | Uss Uss Uss Uss | Uss Uss Uss Uss | Uss Uss Uss Uss | Uss Uss Uss Uss |

In der Tabelle stehen die unter "Funktion" angegebenen Abkkürzungen

```
W1 (11,12)   für "Zeile 1 löschen",
Wo (11)      für "Zeile 11 schreiben",
R  (11,12)   für Zeile 1 lesen" und
St           für "Warten".
```

Tabelle II gibt ergänzend dazu die jeder Funktion zugeordneten Potentiale der Substratzonen Wn, die für alle Zeilen der Matrix gleich sind.

**Tabelle II**

| Funktion | X | Wn |
|---|---|---|
| W1 | Uss | Uss |
| Wo | Uss | Up |
| R | Uss | Udd |
| St | Uss | Uss |

Die Leitungen X und Wn, die in Tabelle II aufgeführt sind, sind in den Figuren 1 bis 4 in runde Klammern als Zeichen dafür gesetzt, daß sie nicht spalten- oder zeilenweise zugeordnet sind, sondern alle Zellen mit gleichem Potential, je nach Funktion, versorgen.

Für die Praxis typische Spannungswerte sind:

$$Up = 20V$$

$$Udd = 5V$$

$$Uss = 0V$$

Über die Auswahltransistoren Tn1 und Tp1 wird die Spannungsversorgung beim Programmieren und beim Lesen gesteuert.

Beim Löschen W1 werden in der adressierten Zeile die Auswahltransistoren Tn1 durch Udd an der Zeilenwahlleitung Zn leitend gesteuert, während die Auswahltransistoren Tp1 mit Udd an der Zeilenwahlleitung Zp gesperrt bleiben. Das Nullpotential der ersten Bitleitung X wird daher über Tn1 und Tn2 zum Injektor I geleitet. Up am Steuergate P hebt das Potential des Speichergates durch kapazitive Kopplung fast auf die gleiche Höhe, macht Tn2 - unabhängig von seinem Programmierzustand - leitend und erzeugt damit bei allen Ausführungsformen der Speicherzelle am dünnen Tunneloxid des Injektors die nötige Feldstärke, um Elektronen ins Speichergate tunneln zu lassen. Diese negative Ladungen im Speichergate verschieben die wirksamen Schwellenspannungen der Speichertransistoren Tn2 und Tp2 in positive Richtung um $\Delta$ Ut: alle Zellen der Zeile werden gelöscht.

Beim Schreiben Wo wird in der adressierten Zeile der Auswahltransistoren Tn1 gesperrt und der Auswahltransistor Tp1 leitend gesteuert. Da die Substratzone Wn gleichzeitig auf Up angehoben wird, kann von der zweiten Bitleitung Y, der Source-Seite von Tp1, die volle Spannung Up durch Tp1 und erforderlichenfalls auch durch Tp2 zum Injektor gelangen. Das Potential Uss = 0 am Steuergate G bringt zur selben Zeit durch kapazitive Kopplung über die Programmierleitung P das Speichergate Fg potential entsprechend nach unten und erzeugt so die nötige Feldstärke am Injektor, um Elektronen vom Speichergate Fg zum Injektor nach unten tunneln zu lassen. Nur diejenigen Zellen der adressierten Zeile, deren Y-Bitleitung an Up liegt, werden so durch Absenkung der Schwellenspannung um $\Delta$ Ut proportional zur Zahl der abgeflossenen Elektronen, geschrieben. Die restlichen Zellen der adressierten Zeile erhalten über die zugehörige zweite Y-Leitung Uss = 0 zugeführt. Das Potential des Injektors bleibt dabei auf einem positiven Wert stehen, der dem Betrag der Schwellenspannung des Auswahltransistors Tp1 entspricht. Dieser Wert ist klein genug, um eine hier nicht erwünschte Programmierung zu verhindern.

Beim Lesen R werden in der adressierten Zeile beide Auswahltransistoren Tn1, Tp1 leitend gesteuert, so daß der aus den Speichertransistoren Tn2 und Tp2 aufgebaute CMOS-Inverter mit Spannung versorgt wird. Am Ausgang dieses Speicherinverters, der mit der Leseleitung verbunden ist, stellt sich das Potential Udd ein, falls die Zelle gelöscht ist, d. h. wenn das den Speichertransistor Tn2 und Tp2 gemeinsame Speichergate nach einer W1-Programmierung einen Überschuß an negativer Ladung besitzt. Umgekehrt stellt sich an der Leseleitung das Potential Uss = 0 ein, wenn die Zelle zuletzt durch Wo-Schreiben programmiert wurde und somit das Speichergate eine positive Überschußladung besitzt.

In den nicht adressierten Zeilen sind beide Auswahltransistoren gesperrt. Das Potential der Leseleitung einer Spalte erfährt daher durch die nicht-adressierten Zeilen keine störende Beeinflussung.

Ein wichtiges Problem bei nichtflüchtigen Speicherzellen ist die Vermeidung von Datenverlust in der Speichermatrix durch unbeabsichtigte Programmier- oder Löschvorgänge in nicht adressierten Zeilen oder Spalten. Ein solcher Datenverlust kann langsam und allmählich eintreten durch die sich akkummulierende Wirkung vieler Programmiervorgänge in benachbarten Zeilen oder Zellen. Auch beim Auslesen von Daten kann nach sehr vielen Lesevorgängen ein gewisser Datenverlust eintreten.

Um dies nach Möglichkeit zu vermeiden, muß angestrebt werden, daß bei keiner Zelle der Speichermatrix, die nicht gerade programmiert wird, zwischen dem Speichergate und der darunterliegenden Injektorelektrode eine überhöhte Potentialdifferenz auftritt.

Das Potential des potentialmäßig schwebenden Speichergates Fg hängt von seinem Programmierzustand ab und ist auf das Potential des Steuergates G bezogen, betragsmäßig etwa gleich der durch die Programmierung bewirkten Schwellenspannungsänderung $\Delta$ Ut aber umgekehrten Verzeichnis. Die Speichergatepotentiale von gelöschten und geschriebenen Zellen weichen also bei symmetrischer Programmierung etwa um -/$\Delta$ Ut/ bzw. +/$\Delta$ Ut/ vom Potential des Steuergates G ab. Ein optimaler Zustand für gute Datenhaltung ist daher gegeben, wenn das Potential des Injektors in der Mitte zwischen den Speichergatepotentialen geschriebener und gelöschter Zellen liegt, d. h. aber: wenn es gleich dem Potential des Steuergates G ist.

Bei den nicht-adressierten Zeilen liegt die Programmierleitung P, wie aus Tabelle 1 ersichtlich ist, generell auf den Nullpotential Uss. Beim Wo-Schreiben, wenn die Substratzone Wn auf Up liegt, werden die Zellen der nicht-adressierten Zeilen auf der P-Kanalseite durch das Potential Up an der Wortleitung Zp gesperrt. Da nun die Substratzone Wn während der Wo-Programmierung auf Up liegt. stellt sich das Potential am Injektor bei gelöschten Zellen gemäß der Konkurrenz zwischen dem Sperrstrom des N+P-Übergangs im P-Substrat einerseits und dem Sperrstrom der P+N-Übergangs in der N-Substratzone Wn andererseits ein, was einer Scherung der beiden Sperrkennlinien entspricht. Um sicher zu sein, daß sich am Injektor das erwünschte Nullpotential einstellt, muß daher durch geeignete Maßnahmen dafür gesorgt werden, daß der Sperrstrom des N+P-Übergangs, der den Injektor umgibt, gegenüber dem Sperrstrom des P+ N-Übergangs der Drainzone Dp2 von Tp2 deutlich überwiegt.

Es ist daher vorteilhaft, bei der Speicherzelle nach der Erfindung in ihren Ausführungsformen gemäß den Figuren 1 bis 3, im Bereich des den N-Injektor umgebenden N+P-Übergangs durch einem Ionenimplantationsprozeß gezielt Rekombinationszentren zu erzeugen, die den Sperrstrom des N+P-Übergangs so erhöhen, daß er den Sperrstrom des P+N-Übergang in der Drainzone Dp2 von Tp2 etwa um den Faktor 30 bis 100 übertrifft.

Bei der in Fig. 4 dargestellten Ausführungsform der Speicherzelle nach der Erfindung wird dieses Problem in anderer Weise gelöst. Die Drainseite des Speichertransistors Tn2 wird über einen Feldeffekttransistor Tn3 des Verarmungstyps direkt mit der ersten Bitleitung X, die an Uss = o liegt, verbunden. Die Gateelektrode dieses Transistors ist ebenfalls mit der ersten Bitleitung X verbunden, so daß der Transistor als Konstandstromquelle geschaltet ist.

Durch gezielte Ionenimplantation im Kanalgebiet von Tn3 wird die Schwellenspannung des Transistors so verschoben, daß sein Pinchoff-Strom im sogenannten Subthresholdgebiet liegt. Der Pinchoff-Strom wird mit Hilfe der Ionenimplantation so eingestellt, daß er den Sperrstrom des P+N-Übergangs auf der Drainseite von Tp2 etwa um den Faktor 30 bis 100 übertrifft. Je nach der Grunddotierung des p-dotierten Substrats werden bei dieser Implantation Bor- bzw. Arsen- oder Phosphorionen benutzt.

Die Ausführungsform der Speicherzelle nach der Erfindung gemäß der Fig. 1 kann realisiert werden, wie es anhand der Fig. 6 und 7 veranschaulicht ist. Die in Fig. 7 gezeigte Aufsicht auf einen Teil einer Speichermatrix entspricht der Teilschnittansicht gemäß der Fig. 6 bis auf die Lage des Al-Kontaktes auf der N-Kanalseite relativ zum Tunnelinjektor In. Eine Zeile von Speicherzellen liegt zwischen den Begrenzungslinien 8 und 9. Die Speicherzellen der benachbarten Zeile sind Spiegelbildlich zu diesen Linien ausgelegt.

Dieser Al-Kontakt liegt bei der Ausführungsform gemäß der Fig. 6 zwischen den beiden Drainzonen Dp2 und Dn2, während er bei der Abwandlung gemäß der Fig. 7 am Ansatz A der Drainzone Dn2 zwischen dem als Drainzone wirksamen Bereich und dem diagonal durchkreuzten Kontaktierungsbereich der Leseleitung L angeordnet ist.

Zur Herstellung der Ausführungsform gemäß den Fig. 6 und 7 wird von einem p-dotierten Halbleiterkörper 1 ausgegangen, in den oberflächlich zuerst die n-dotierte Substratzone 2 eindiffundiert wurde und dann nacheinander die n- und p-dotierten Source- und Drainbereiche durch Ionenimplantation mit anschließender Diffusion im Bereich des Substrats 1 bzw. im Bereich der Substratzone 2 eingebracht wurden. Anschließend werden die SDG-Bereiche mit einer gegen Oxidation des Siliciums wirksamen Oxidationsmaskierungsschicht aus Siliciumnitrid, wie es aus "IEEE Transactions on Electron Devices" Bd. 13 (Juli 1966), Seiten 561 bis 563 bekannt ist, abgedeckt. Durch thermische Oxidation wird außerhalb der erwähnten Bereiche das Dickoxid 3 erzeugt. Nach Entfernung der Oxidationsmaskierungsschicht werden in zwei Oxidationsprozessen zuerst das Gateoxid in den Gatebereichen der Transistoren Tp1, Tp2, Tn2 und Tn1 und dann im Bereich des Injektors nach einer selektiven Ätzung die Tunnelisolatorschicht It in einer Dicke zwischen 10 und 15 nm durch Oxidation erzeugt. Anschließend wird über die Anordnung einer erste Schicht 6 aus n-dotierten polykristallinem Silicium aufgebracht, aus der die Zeilenwahlleitungen mit den Gateelektroden der Transistoren und das Speichergate Fg herausgeätzt werden. Das Speichergate Fg und das Steuergate G erhält die Durchbrüche 4 und 5 (Fig. 7).

Nach einer weiteren thermischen Oxidation der freiliegenden Polysiliciumoberfläche der ersten Schicht 6 wird abermals über die gesamte Anordnung eine zweite Schicht 7 aus polykristallinem Silicium aufgebracht, aus der das Steuergate G zeilenweise zusammenhängend mit den Steuergates der benachbarten Speicherzelle herausgearbeitet wird, so daß diese Schicht als Programmierleitung P verwendbar ist.

Nach Aufbringen einer Fremoxidschicht werden senkrecht zu den Zeilenwahlleitungen Zn2 und Zp2 die Leseleitung L, welche die Drainzonen Dn2 und Dp2 kontaktiert, und die zweite Bitleitung Y, welche die Sourcezone des Auswahltransistors Tp1 kontaktiert, aus einer über die Anordnung aufgebrachte Al-Schicht herausgeätzt.

Die n-dotierten Substratzonen (2) der Speicherzellen werden zeilenweise quer durch die Speichermatrix geführt, werden aber außerhalb der Matrix galvanisch miteinander verbunden. Die erste Bitleitung X wird durch Diffusion bei der Ausbildung der n-dotierten Zonen hergestellt unh erstreckt sich bei dieser Ausführung in Zeilenrichtung. An ihr wird das Potential Uss angelegt.

Die Fig. 8 zeigt eine Maskenauslegung der Ausführungsform gemäß der Fig. 3, die je einen in der Mitte der Kanalgebiete der beiden Speichertransistoren Tn2 und Tp2 liegenden Injektor In und Ip zeigt. Bei dieser Ausführungsform werden ebenfalls zwei Leitschichten 6 und 7 aus polykristallinem Silicium aufgebracht. Aus der zuerst aufgebrachten werden die in einer Richtung quer zu den Bitleitungen X und Y verlaufenden Zeilenwahlleitungen Zp2 und Zn2 gleichzeitig die Speicherelektrode Fg ausgeätzt.

Da bei dem Ausführungsbeispiel gemäß der Fig. 8 zur Herstellung der Zonen entsprechend dem Standard-Silicium-Gate-Prozeß Ionenimplantationen verwendet werden, fehlen bei der Fig. 8 - unterschiedlich zu der Fig. 7 - die Linien der Unterdiffusionen. Die Speicherzellen der benachbarten Speicherzellen sind spiegelbildlich um die Begrenzungslinien 8 und 9 der dargestellten Speicherzelle ausgelegt. Die Steuergates G mit der sie verbindenden Programmierleitungen P werden aus der zuoberst aufgebrachten Schicht 7 aus polykristallinem Silicium herausgeätzt. Die strukturierte untere Schicht 6 aus n-dotiertem polykristallinem Silicium wird als Maskierung für die beiden Implantationsprozesse zur Herstellung der in der Fig. 8 nicht unterschiedlich dargestellten N+- und P+-Zonen verwendet. Für die Herstellung der beiden Tunnelisolatorschichten Itn und Itp der beiden Injektoren In und Ip kommt eine besondere Photomaske zur Anwendung.

Die Ionenimplantation zur Erhöhung des Sperrstroms des N+P-Übergangs in der Umgebung des N-Injektors wird in beiden Prozeßbeispielen vor oder nach der Gateoxidation durchgeführt.

**Patentansprüche**

1. Elektrisch programmierbare, zu einer Speichermatrix gehörende Speicherzelle, welche als Source-Drain-Reihenschaltung von Feldeffekttransistoren aus einem Koppelteil und einem Speicherteil mit einem potentialmäßig schwebendem Speichergate (Fg) aufgebaut ist, welch letzteres kapazitiv an ein Steuergate (G) gekoppelt und mittels einer Injektoreinrichtung mit Tunnelübergang umladbar ist, wobei
- die Reihenschaltung zwischen einer ersten Bitleitung (X) und einer zweiten Bitleitung (Y) liegt und
- das Steuergate (G) mit einer Programmierleitung (P) verbunden ist,
<u>dadurch gekennzeichnet,</u>
- daß der Speicherteil aus einem Paar von komplementären Feldeffektspeichertransistoren (Tn2, Tp2) besteht, deren Drainzonen im Mittelpunkt der Reihenschaltung durch eine leitende Brücke miteinander verbunden sind,
- daß die Speichergates der Speichertransistoren (Tn2, Tp2) zu einem gemeinsamen Speichergate (Fg) miteinander verbunden sind und aus einer zusammenhängenden Schicht aus Polysilicium bestehen, welche mittels der Injektoreinrichtung (I, In, Ip) umladbar ist,
- daß die Steuergates (G) der Speichertransistoren (Tn2, Tp2) miteinander verbunden sind,
- daß jeder der beiden Speichertransistoren (Tn2, Tp2) auf seiner Sourceseite mit der Drainzone eines Auswahltransistors (Tn1, TP2) gleichen Leitungstyps verbunden ist,
- daß die Auswahltransistoren (Tn1, Tp1) die zusammen den Koppelteil der Reihenschaltung bilden mit ihrer Sourceseite jeweils an eine der Bitleitungen (X, Y) angeschlossen sind und mit ihren Gateelektroden an je einer der Wortleitungen (Zn, Zp) liegen,
- daß die Drainzonen der Speichertransistoren (Tn2, Tp2) im Mittelpunkt der Reihenschaltung mit einer Leseleitung (L) verbunden sind, die einer Matrixspalte gemeinsam ist, und
- daß die N-Kanaltransistoren (Tn1, Tn2) in einem p-dotierten Substrat und die P-Kanaltransistoren (Tp1, Tp2) zeilenweise in je einer n-dotierten Substratzone (2) angeordnet sind, wobei die Substratzone eine Gliederung nach Zeilen aufweist.

2. Speicherzelle nach Anspruch 1, dadurch gekennzeichnet, daß die Injektoreinrichtung aus einem Injektor (In) besteht, der innerhalb der n-dotierten Drainzone des N-Kanalspeichertransistors (Tn2) oder in einem Ansatz (A) von dessen Drainzone (Dn) angeordnet ist, wobei der Injektor (In) an der betreffenden Stelle aus einer kleinflächigen dünnen Tunnelisolatorschicht (It) zwischen der Oberfläche der Drainzone (Dn) und dem Speichergate (Fg) besteht.

3. Speicherzelle nach Anspruch 2, dadurch gekennzeichnet, daß die Injektoreinrichtung außer einem ersten Injektor (In) noch einen zweiten Injektor (Ip) aufweist, der innerhalb der p-dotierten Drainzone des P-Kanalspeichertransistors (Tp2) oder einem Ansatz von dessen Drainzone angeordnet ist.

**0 103 043**

4. Speicherzelle nach Anspruch 1, dadurch gekennzeichnet, daß die Injektoreinrichtung einen ersten Injektor (In), der innerhalb der n-dotierten Sourcezone des Speichertransistors (Tn2) oder in einem Ansatz (A) derselben angeordnet ist, und außerdem einen zweiten Injektor (Ip) enthält, der innerhalb der p-dotierten Sourcezone des Speichertransistor (Tp2) oder in einem Ansatz (A) derselben angeordnet ist, wobei die Injektoren (In, Ip) durch je eine kleinflächige dünne Tunnelisolatorschicht (Itn, Itp) zwischen der Oberfläche der Sourcezonen und dem Speichergate (Fg) definiert sind.

5. Speicherzelle nach Anspruch 1, dadurch gekennzeichnet, daß die Injektoreinrichtung einen ersten Injektor (In) aufweist, der innerhalb der Kanalzone zwischen Sourcezone und Drainzone des N-Kanalspeichertransistors (Tn2) und außerdem einen zweiten Injektor (Ip) enthält, der innerhalb der Kanalzone des P-Kanalspeichertransistors (Tp2) angeordnet ist und daß die Injektoren (In, Ip) durch je eine dünne Tunnelisolatorschicht (Itn, Itp) an den betreffenden Stellen der Kanalzonen des Gateoxids definiert sind.

6. Speicherzelle nach einem der Ansprüche 1 bis 5, dadurch gekennzeichnet, daß der N+P-Übergang zwischen der n-dotierten Drainzone des N-Kanalspeichertransistor (Tn2) und dem p-dotierten Substrat bei der Spannung Up 20V einen um den Faktor 30 bis 100 größeren Sperrstrom aufweist, als der P+N-Übergang zwischen der p-dotierten Drainzone des P-Kanalspeichertransistors (Tp2) und der n-dotierten Substratzone (Wn).

7. Speicherzelle nach Anspruch 6, dadurch gekennzeichnet, daß der vergrößerte Sperrstrom durch lokale Ionenimplantationen mit Fremdionen (z.B. Ar) erzeugt wird.

8. Speicherzelle nach Anspruch 2 oder 3, dadurch gekennzeichnet, daß die n-dotierte Drainzone des N-Kanalspeichertransistors (Tn2) mit der n-dotierten Sourcezone des N-Kanalauswahltransistors (Tn1) über einen N-Kanalfeldeffekttransistor (Tn3) des Verarmungstyps verbunden ist, dessen Gateelektrode ebenfalls mit der Sourcezone des N-Kanalauswahltransistors (Tn1) verbunden ist und dessen Pinchoff-Strom im Subthresholdbereich liegt.

9. Speicherzelle nach Anspruch 8, dadaurch gekennzeichnet, daß der Pinchoff-Strom des N-Kanalfeldeffekttransistors (Tn3) durch Ionenimplantation so eingestellt ist, daß er um den Faktor 30 bis 100 größer ist als der Sperrstrom des P+N-Übergangs der p-dotierten Drainzone des P-Kanalspeichertransistors (Tp2).

10. Speicherzelle nach den Ansprüchen 2 bis 9, dadurch gekennzeichnet, daß die Tunnelisolatorschicht aus thermisch gewachsenem Siliziumdioxid besteht und eine Dicke von 10 bis 20 nm aufweist.

## Claims

1. Electrically programmable memory cell forming part of a memory matrix and which, in the form of a source-drain series arrangement of field-effect transistors, is composed of a coupling part and of a storage part comprising an electrically floating storage gate (Fg), with the latter being capacitively coupled to a control gate (G) and capable of being recharged by means of an injector device with a tunnel junction, wherein
- the series arrangement is located between a first bit line (X) and a second bit line (Y), and
- the control gate (G) is connected to a programminy line (P),
characterized in
- that the storage part consists of a pair of complementary field-effect memory transistors (Tn2, TpP) with the drain regions thereof being connected to one another in the center point of the series arrangement by way of a conducting bridge,
- that the storage gates of the memory transistors (Tn2 , Tp2) are connected to one another to form a common storage gate (Fg) and consist of a continuous layer of polysilicon which is capable of being recharged by means of the injector device (I, In, Ip),
- that the control gates (G) of the memory transistors (Tn2, Tp2) are connected to one another,
- that each of the two memory transistors (Tn2, Tp2) is connected on its source side to the drain region of a select transistor (Tn1, Tp2) of the same conductivity type,
- that the select transistors (Tn1, Tpl) which together form the coupling part of the series arrangement, are each connected with their source side to one of the bit lines (X, Y) and are connected with their gate electrodes to each time one of the word lines (Zn, Zp),
- that the drain regions of the memory transistors (Tn2, Tp2) are connected in the center point of the series arrangement to a read line (L) which is provided for in common to one matrix column, and
- that the n-type channel transistors (Tn1, Tn2) are arranged in a p-doped substrate, and that the p-type channel transistors (Tp1, Tp2) are arranged row-wisely in each time one n-doped substrate region (2), with said substrate region being divided in accordance with the rows.

2. A memory cell as claimed in claim 1, characterized in that the injector device consists of an injector (In) which is arranged either within the n-doped drain region of the n-type channel memory transistor (Tn2) or in an extension (A) of the drain region (Dn) thereof, with said injector (In) consisting at the respective point of a small-surface type and thin tunnel insulating layer (It) between the surface of the drain region (Dn) and the storage gate (Fg).

3. A memory cell as claimed in claim 2, characterized in that said injector device, apart from a first injector

7

(In) still comprises a second injector (Ip) which is arranged either within the p-doped drain region of the p-type channel memory transistor (Tp2) or in an extension of the drain region thereof.

4. A memory cell as claimed in claim 1, characterized in that said injector device contains first injector (In) which is arranged either within the n-doped source region of the memory transistor (Tn2) or in an extension (A) thereof and, in addition thereto, contains a second injector (Ip) which is arranged, either within the p-doped source region of the memory transistor (Tp2) or in an extension (A) thereof, with said injectors (In, Ip) each being defined by a small-surface type of thin tunnel insulating layer (Itn, Itp) between the surface of the source regions and said storage gate (Fg).

5. A memory cell as claimed in claim 1, characterized in that said injector device comprises a first injector (In) which is arranged within the channel region between the source region and the drain region of the n-type channel memory transistor (Tn2) and, in adcition thereto, comprises a second injector (Ip) which is arranged within the channel region of the p-type channel memory transistor (Tp2), and that said injectors (In, Ip) are each defined by a thin tunnel insulating layer (Itn, Itp) at the respective points of the channel regions of the gate oxide.

6. A memory cell as claimed in any one of claims 1 to 5, characterized in that the n+p-junction between the n-doped drain region of the n-type channel memory transistor (Tn2) and the p-doped substrate, at a voltage Up=20 V, shows to have a reverse current which is greater by the factor 30 to 100, than the p+ n-junction between the p-doped drain region of the p-type channel memory transistor (Tp2) and the n-doped substrate region (Wn).

7. A memory cell as claimed in claim 6, characterized in that the enlarged reverse current is produced by way of local ion implantations with foreign ions (such as As).

8. A memory cell as claimed in claims 2 or 3, characterized in that the n-doped drain region of the n-type channel memory transistor (Tn2) is connected to the n-doped source region of the n-type channel select transistor (Tn1) via an n-channel field-effect transistor (Tn3) of the depletion type, with the gate electrode thereof likewise being connected to the source region of the n-type channel select transistor (Tnl), and with the pinch-off current thereof lying within the sub-threshold range.

9. A memory cell as claimed in claim 8, characterized in that the pinch-off current of the n-type channel field-effect transistor (Tn3) is in such a way adjusted by way of ion implantation that it is by the factor 30 to 100 greater than the reverse current of the p+n-junction of the p-doped drain region of the p-type channel memory transistor (Tp2).

10. A memory cell as claimed in claims 2 to 9, characterized in that the tunnel insulating layer consist of thermally grown silicon dioxide and has a thickness ranging between 10 and 20 nm.

## Revendications

1. Cellule de mémoire programmable électriquement faisant partie d'une matrice de mémoire et qui, sous la forme d'un montage en série des trajets source-drain de transistors à effet de champ, est composée d'une partie de couplage et d'une partie de mémorisation comprenant une grille de mémorisation flottant électriquement (Fg), cette dernière étant couplée capacitivement à une grille de commande (G) et pouvant être rechargée par un dispositif d'injection comprenant une jonction tunnel, dans laquelle:
- le montage en série est compris entre une première ligne de bit (X) et une seconde ligne de bit (Y) et
- l'électrode de commande (G) est connectée à une ligne de programmation (P),
caractérisée en ce que:
- la partie de mémorisation consiste en une paire de transistors de mémoire à effet de champ complémentaires (Tn2, Tp2) dont les zones de drain sont connectées l'une à l'autre au point central du montage en série par un pont conducteur,
- les grilles de mémorisation des transistors de mémoire (Tn2, Tp2) sont connectées l'une à l'autre pour former une grille de mémorisation commune (Fg) et sont constituées d'une couche continue de silicium polycristallin pouvant être rechargée par un dispositif d'injection (I, In, Ip),
- les grilles de commande (8) des transistors de mémoire (Tn2, Tp2) sont connectées l'une à l'autre,
- chacun des deux transistors de mémoire (Tn2, Tp2) est connecté du coté source à la zone de drain d'un transistor de sélection (Tn1, Tp2) du même type de conductibilité,
- les transistors de sélection (Tn1, Tp1) qui forment ensemble la partie de couplage du montage en série sont connectés chacun du côté source à l'une des lignes de bit (X, Y) et sont respectivement connectés par leurs électrode de grille à l'une des lignes de mot (Zn, Zp),
- les zones de drain des transistors de mémoire (Tn2, Tp2), au point central du montage en série, sont connectées à une ligne de lecture (L) qui est commune à une colonne de la matrice, et
- les transistors à canal N (Tn1, Tn2) sont disposés dans un substrat à dopage de type P et les transistors à canal P (Tp1, Tp2) sont disposés, par rangées, chacun dans une zone de substrat à dopage de type N (2), cette zone de substrat étant organisée par rangées.

2. Cellule de mémoire selon la revendication 1, caractérisée en ce que le dispositif d'injection consiste en un injecteur (In) qui est disposé soit dans la zone de drain à dopage N du transistor de mémoire à canal N (Tn2) ou dans une extension (a) de la zone de drain (Dn) de celui-ci, cet injecteur (In) consistant, en cet emplacement,

8

en une couche isolante mince à effet tunnel de petite surface (It) entre la surface de la zone de drain (Dn) et la grille de mémorisation (Fg).

3. Cellule de mémoire selon la revendication 2, caractérisée en ce que le dispositif d'injection, outre un premier injecteur (In), comprend un second injecteur (Ip) disposé soit dans la zone de drain à dopage P d'un transistor de mémoire à canal P (Tp2) ou dans une extension de la zone de drain de celui-ci.

4. Cellule de mémoire selon la revendication 1, caractérisée en ce que le dispositif d'injection comprend un premier injecteur (In) disposé soit dans la zone de source à dopage N du transistor de mémoire (Tn2) ou dans une extension (a) de celle-ci et, en outre, comprend un deuxième injecteur (Ip) qui est disposé soit dans la zone de source à dopage P du transistor de mémoire (Tp2) ou dans une extension (a) de celle-ci, ces injecteurs (In, Ip) étant chacun défini par une couche isolante mince à effet tunnel de petite surface (Itn, Itp) entre la surface des régions de source et la grille de mémorisation (Fg).

5. Cellule de mémoire selon la revendication 1, caractérisée en ce que le dispositif d'injection comprend un premier injecteur (In) qui est disposé dans la zone de canal entre la zone de source et la zone de drain du transistor de mémoire à canal N (Tn2) et, en outre, comprend un deuxième injecteur (Ip) disposé dans la zone de canal du transistor de mémoire à canal P (Tp2), et en ce que les injecteurs (In, Ip) sont définis chacun par une couche isolante mince (Itn, Itp), en ces emplacements, des couches d'oxyde de grille des zones de canal.

6. Cellule de mémoire selon l'une quelconque des revendications 1 à 5, caractérisée en ce que la jonction N+P entre la zone de drain à dopage N du transistor de mémoire à canal N (Tn2) et le substrat à dopage P, à une tension Up = 20 V, présente un courant inverse qui est plus grand d'un facteur de 30 à 100 que la jonction P+N entre la zone de drain à dopage P du transistor de mémoire à canal P (Tp2) et la zone de substrat à dopage N (Wn).

7. Cellule de mémoire selon la revendication 6, caractérisée en ce que le courant inverse plus important est obtenu par des implantations localisées d'ions étrangers (tel que l'As).

8. Cellule de mémoire selon la revendication 2 ou 3, caractérisée en ce que la zone de drain à dopage N du transistor de mémoire à canal N (Tn2) est connectée à la zone de source à dopage N du transitor de sélection à canal N (Tn1) par l'intermédiaire d'un transistor à effet de champ à canal N (Tn3) du type à appauvrissement, dont l'électrode de grille est de même connectée à la zone de source du transistor de sélection à canal N (Tn1), le coude de courant de celui-ci étant dans la plage inférieur au seuil.

9. Cellule de mémoire selon la revendication 8, caractérisée en ce que le coude de courant du transistor à effet de champ à canal N (Tn3) est ajusté par implantation ionique, de sorte qu'il est plus grand d'un facteur de 30 à 100 que le courant inverse de la joncion P+N de la zone de drain à dopage P du transistor de mémoire à canal P (Tp2).

10. Cellule de mémoire selon les revendications 2 à 9, caractérisée en ce que la couche d'isolement à effet tunnel consiste en dioxyde de silicium obtenu par croissance thermique et a une épaisseur de 10 à 20 nm.

# FIG.1

Zn
Zp
P

Tn1    Tn2    Tp2    Tp1

(Wn)

In

L (X)    Y

# FIG.2

Zn
Zp
P

Tn1    Tn2    Tp2    Tp1

(Wn)

In    Ip

L (X)    Y

# FIG. 3

Zn
Zp
P

Tn1    Tn2    Tp2    Tp1

In    Ip

(Wn)

L (X)    Y

# FIG. 4

Zn
Zp
P

Tn1    Tn2    Tp2    Tp1

In

(Wn)

Tn3

L (X)    Y

## FIG. 5

## FIG. 6

## FIG. 7

# FIG.8